Europäisches Patentamt

European Patent Office

Office européen des brevets

(11) Numéro de publication: **0 475 532 A1**

# DEMANDE DE BREVET EUROPEEN

(21) Numéro de dépôt: **91202312.4**

(22) Date de dépôt: **10.09.91**

(51) Int. Cl.5: **H03H 11/12**

(30) Priorité: **14.09.90 FR 9011379**

(43) Date de publication de la demande:
**18.03.92 Bulletin 92/12**

(84) Etats contractants désignés:
**DE FR GB IT**

(71) Demandeur: **LABORATOIRES D'ELECTRONIOUE PHILIPS**
**22, Avenue Descartes**
**F-94450 Limeil-Brévannes(FR)**
(84) **FR**

(71) Demandeur: **N.V. Philips' Gloeilampenfabrieken**
**Groenewoudseweg 1**
**NL-5621 BA Eindhoven(NL)**
(84) **DE GB IT**

(72) Inventeur: **Deville, Yannick**
**Société Civile S.P.I.D., 156, Boulevard Haussmann**
**F-75008 Paris(FR)**

(74) Mandataire: **Charpail, François et al**
**Société Civile S.P.I.D. 156, Boulevard Haussmann**
**F-75008 Paris(FR)**

(54) **Dispositif semi-conducteur intégré comprenant une structure de filtre passe-bas à réactions multiples.**

(57) Dispositif semiconducteur intégré incluant une structure de filtre passe-bas à réactions multiples, cette structure comprenant une chaîne directe formée d'au moins deux blocs-filtres à gain négatif montés en série, et deux chaînes de réactions multiples (1,2), la première à gain négatif, la seconde à gain positif ramenant les signaux de sortie des blocs-filtres sur l'entrée de la structure de filtre à travers un sommateur. Ce dispositif est caractérisé en ce que :
- chaque bloc-filtre de la chaîne directe est un passe-bas d'ordre 1 comprenant un circuit R-C ($r_j$, $c_j$) et un étage amplificateur ($C_j$) à gain négatif formant une source de courant commandée en tension ($E_j$ dont les éléments réels et intrinsèques sont pris en compte dans la structure du circuit R-C pour le calcul de la fonction de transfert,
- la première chaîne de réactions multiples renvoie sur l'entrée de la structure de filtre une première somme de fractions de toutes les tensions de sortie des blocs-filtres de position paire de la chaîne directe pondérées par des coefficients d'amplification négatifs,
- la seconde chaîne de réactions multiples renvoie sur l'entrée de la structure de filtre une seconde somme de fractions de toutes les tensions de sortie des blocs-filtres de position impaire de la chaîne directe pondérées par des coefficients d'amplification positifs.

EP 0 475 532 A1

FIG. 4a

FIG. 4b

L'invention concerne un dispositif semiconducteur intégré incluant une structure de filtre passe-bas à réactions multiples, cette structure comprenant une chaîne directe formée d'au moins deux blocs-filtres à gain négatif montés en série, et deux chaînes de réactions multiples, la première à gain négatif, la seconde à gain positif ramenant les signaux de sortie des blocs-filtres sur l'entrée de la structure de filtre à travers un sommateur.

L'invention trouve son application dans la réalisation de filtres passe-bas fonctionnant dans le domaine des hyperfréquences et dont la courbe représentant le gain en fonction de la fréquence présente des flancs abrupts conformes à un gabarit donné.

L'invention trouve notamment son application dans le domaine de la télévision. Dans ce domaine, par exemple, il est nécessaire d'avoir la possibilité de sélectionner un signal situé dans un canal, c'est-à-dire dans une bande de fréquences étroite, ce canal pouvant lui-même se trouver dans une bande de fréquences plus large. En outre, il est nécessaire d'avoir la possibilité de déplacer la sélection du canal en cours d'utilisation, lorsque l'on désire recevoir un signal différent situé dans un autre canal.

Dans le domaine cité de la télévision, il est connu de l'homme du métier d'utiliser un filtre à forte sélectivité, ajustable, pour fournir à sa sortie les signaux qui sont à l'intérieur du canal sélectionné.

Mais si l'on envoie sur un tel filtre un signal qui n'a pas été préalablement traité, par exemple un signal venant directement d'une antenne, alors des problèmes apparaissent. En effet, le filtre sélectif reçoit, outre les signaux que l'on désire utiliser, une quantité d'autres signaux indésirables qui ne sont pas dans la bande d'utilisation, mais qui sont néanmoins captés par l'antenne. Il se produit alors un mélange entre tous ces signaux, et, lorsque les signaux indésirables sont à une fréquence extérieure à celle de la bande d'utilisation, il apparaît ainsi des signaux à la même fréquence que celle des signaux utiles et qui les parasitent.

Outre ce parasitage, ces signaux indésirables procurent un autre inconvénient : ils résultent en une forte puissance d'entrée appliquée sur le filtre sélectif. Ce dernier fonctionne alors de manière non linéaire et distord le signal utile qu'il reçoit.

La solution à ces problèmes réside dans un filtre passe-bas non ajustable placé en amont du filtre sélectif ajustable.

Le circuit selon l'invention trouve aussi son application dans la réalisation de tout filtre passe-bas, par exemple pour éliminer les harmoniques d'un signal ; ou dans les démodulateurs pour éliminer les signaux aux fréquences images.

Un circuit de filtre tel que décrit dans le préambule de la revendication 1 est connu du brevet US 3720881 de Mars 1973. Ce brevet décrit des filtres basse fréquences, passe-bande à passe-bas, à réactions multiples, composés de blocs de base montés en cascade, et de résistances disposées à la sortie des blocs pour ramener en entrée le signal de sortie de chaque bloc. La valeur de chacune des résistances est choisie pour réaliser la fonction de transfert voulue du circuit filtre à réactions multiples.

Le brevet US cité décrit deux types de circuits filtres : une structure passe-bande, et une structure passebas, non intégrables.

Dans le cas de la structure passe-bas, les réactions multiples sont toutes ramenées directement au même noeud d'entrée d'un amplificateur opérationnel faisant office de sommateur. Les réactions ne sont faites qu'à partir de la sortie du second bloc de base. Chaque bloc de base est constitué d'un pont diviseur à résistance et capacité, et d'un amplificateur à gain unitaire positif contenant un amplificateur opérationnel et servant de tampon. Ce bloc de base est également un filtre passe-bas d'ordre 1 de fréquence centrale identique d'un bloc de base à l'autre, et identique à la fréquence centrale du filtre complet. Les contre-réactions ont toutes un gain négatif et sont purement résistives. Chaque bloc de base a peu d'effet sur le bloc précédent ou suivant, du fait de son amplificateur tampon. Les seuls paramètres à prendre en compte pour le calcul des éléments du bloc de base sont la résistance, la capacité, et la fréquence centrale du filtre complet. Le cas est illustré par les figures 3 et 4 du brevet US cité.

Dans le cas de la structure passe-bande les réactions multiples forment deux chaînes sur lesquelles sont appliquées, par l'intermédiaire de résistances, une sortie sur deux des blocs unitaires en alternance. Néanmoins, le premier bloc n'est pas muni de contre-réaction. Toutes les contre-réactions ont un gain négatif et sont purement résistives. Chaque bloc de base est constitué d'un filtre passe-bande d'ordre 2 et d'un amplificateur opérationnel à gain infini. Les blocs de base sont tous identiques et calculés en fonction des résistances, capacités, fréquences centrales -qui sont identiques pour chaque bloc à la fréquence centrale du filtre complet- et facteur qualité. Pour obtenir que les contre-réactions soient toutes à gain négatif, chaque bloc de base ayant un gain négatif, l'une des deux chaînes est munie d'un inverseur. Les réactions multiples sont toutes ramenées au même noeud d'entrée d'un amplificateur opérationnel faisant office de sommateur. Ce cas est illustré par les figures 1 et 2 du brevet US cité.

Les circuits filtres connus du brevet US cité comprennent donc l'un et l'autre, obligatoirement, des amplificateurs opérationnels, lesquels limitent par principe la fréquence de fonctionnement du filtre complet. Ainsi les filtres connus ne peuvent convenir aux applications hautes et hyperfréquences envisagées par la présente invention, notamment dans le domaine de la télévision.

Cela ressort particulièrement de la publication intitulée "Effects of Excess Phase in Multiple-Feed-Back Active Filters" par R. Schaumann et alii" dans "IEEE Transactions on Circuits and Systems, Vol.CAS.27, N°10, October 1980". Cette publication enseigne que les circuits tels que décrits dans le brevet US cité sont limités en fréquence par les imperfections des amplificateurs opérationnels et particulièrement par l'erreur de phase introduite par ces amplificateurs.

Un autre inconvénient inhérent aux circuits décrits par le brevet US est qu'ils ne sont pas intégrables. En effet, les résistances nécessaires pour former les boucles de contre-réactions présentent des valeurs trop fortes pour être intégrables. Un autre inconvénient qui s'oppose à l'intégration est que les valeurs des résistances sont très dispersées (dans un rapport 1 à 200).

Un objet de la présente invention est de fournir des circuits filtres passe-bas évitant les amplificateurs opérationnels, pour permettre le fonctionnement dans le domaine des hyperfréquences.

Un autre objet de l'invention est de fournir de tels circuits en évitant d'utiliser des résistances dont les valeurs sont dispersées, de manière à être facilement intégrables.

Les buts de l'invention sont atteints au moyen d'un circuit muni des éléments décrits dans le préambule de la revendication 1, et en outre caractérisé en ce que :

- chaque bloc-filtre de la chaîne directe est un passe-bas d'ordre 1 comprenant un circuit R-C et un étage amplificateur à gain négatif formant une source de courant commandée en tension dont les éléments réels et intrinsèques sont pris en compte dans la structure du circuit R-C pour le calcul de la fonction de transfert ;
- la première chaîne de réactions multiples renvoie sur l'entrée de la structure de filtre une première somme de fractions de toutes les tensions de sortie des blocs-filtres de position paire de la chaîne directe pondérées par des coefficients d'amplification négatifs ;
- la seconde chaîne de réactions multiples renvoie sur l'entrée de la structure de filtre une seconde somme de fractions de toutes les tensions de sortie des blocs-filtres de position impaire de la chaîne directe pondérées par des coefficients d'amplification positifs.

Le circuit selon l'invention est d'une structure plus simple que celle des circuits connus ; il permet un fonctionnement en hautes et hyperfréquences ; il est facilement intégrable.

L'invention sera mieux comprise au moyen de la description suivante illustrée par les figures schématiques annexées dont :

- la figure 1 qui représente la modélisation d'un transistor à effet de champ ;
- la figure 2 qui représente la modélisation d'un étage amplificateur comprenant un transistor à effet de champ ;
- la figure 3a qui représente à l'aide de blocs fonctionnels, le circuit selon l'invention ;
- la figure 3b qui représente la modélisation du circuit de la figure 3a.
- la figure 4a qui représente à l'aide de blocs de base un exemple de mise en oeuvre du circuit selon l'invention ;
- la figure 4b qui représente un exemple de réalisation d'un bloc de base pour réaliser le circuit de la figure 4a.

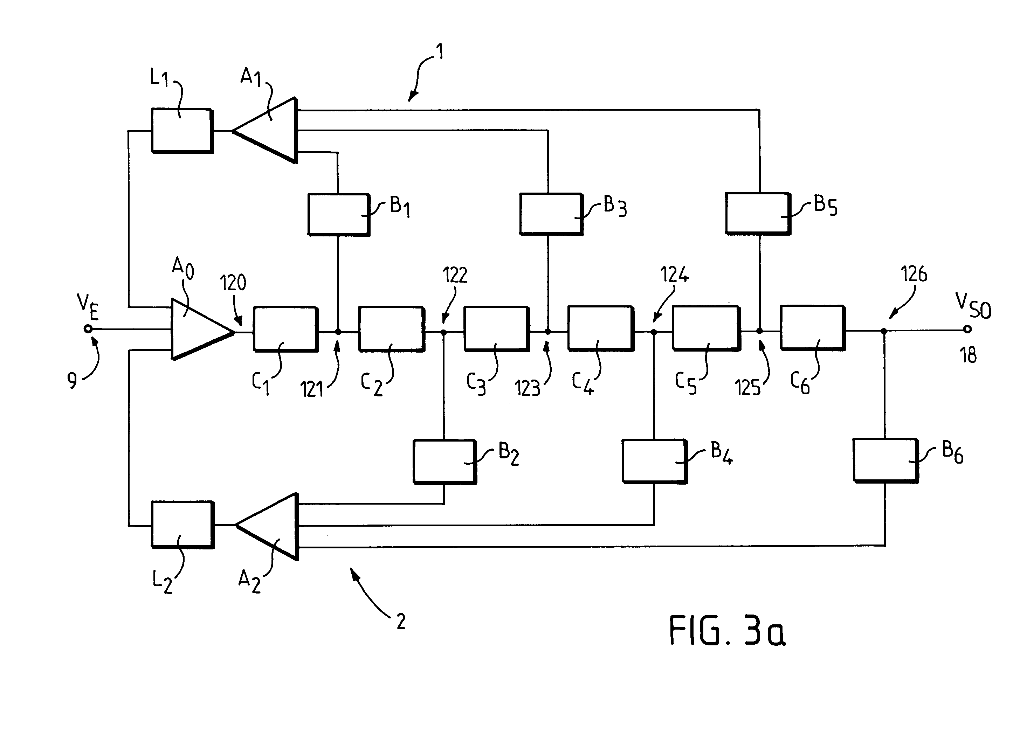

Tel que représenté sur la figure 3a, schématiquement, par blocs, la structure de filtre passe-bas pour hautes et hyperfréquences comprend une chaîne directe formée de n blocs-filtres $C_1$ à $C_n$ d'ordre 1 couplés en série. A titre d'exemple, la chaîne directe de la structure de filtre de la figure 3a comprend 6 blocs-filtres $C_1$, $C_2$, $C_3$, $C_4$, $C_5$ et $C_6$.

La structure de la figure 3a comprend en outre un bloc sommateur $A_0$ effectuant la somme du signal d'entrée $V_E$ appliqué au noeud 9 et des signaux ramenés par deux chaînes de réactions multiples.

La sortie 120 du sommateur $A_0$ constitue l'entrée du premier bloc-filtre $C_1$. La sortie de chacun des blocs filtres $C_j$ est couplée à l'entrée du bloc suivant respectivement aux noeuds 121 à 125. La sortie 126 du dernier bloc $C_6$ est couplée à la sortie 18 du circuit.

La première chaîne 1 des deux chaînes à réactions multiples renvoie à l'entrée du sommateur $A_0$, la somme pondérée des sorties respectivement 121, 123, 125, des blocs de position impaire, respectivement $C_1$, $C_3$, $C_5$. La somme est effectuée par le sommateur $A_1$. La pondération est effectuée par les blocs $B_1$, $B_3$, $B_5$ affectés de coefficients d'amplification $\beta_1$, $\beta_3$, $\beta_5$. La seconde chaîne 2 renvoie à l'entrée du sommateur $A_0$, la somme pondérée des sorties respectivement 122, 124, 126 des blocs de position paire, respectivement $C_2$, $C_4$, $C_6$. La somme est effectuée par le sommateur $A_2$. La pondération est effectuée par les blocs $B_2$, $B_4$, $B_6$ affectés des coefficients d'amplification $\beta_2$, $\beta_4$, $\beta_6$.

La première chaîne est à gain négatif et la seconde chaîne est à gain positif.

4

Dans le circuit représenté à titre d'exemple sur la figure 3a, la structure de filtre passe-bas est d'ordre 6, donc paire. Dans d'autres réalisations, cette structure peut être d'un ordre différent, pourvu que l'ordre soit supérieur ou égal à 2, c'est-à-dire que la structure comporte au moins deux blocs-filtres $C_j$ d'ordre 1 dans la chaîne directe. Le circuit représenté sur la figure 3a n'est pas limitatif.

On cherche donc à réaliser au moyen du circuit de la figure 3a, un filtre passe-bas ayant un gabarit donné, imposé par exemple au concepteur de circuits intégrés par le choix d'une application donnée, en télévision ou dans un autre domaine.

Dans ce qui suit, on se reportera au tableau I toutes les fois qu'une équation ou une relation sera citée.

On a donc à réaliser une fonction de transfert passe-bas donnée, d'ordre n. Cette fonction de transfert peut être écrite selon la relation (1)

où : s est la variable de Laplace,

$\omega_p$ est la pulsation liée à la fréquence de coupure.

Dire que la fonction de transfert est donnée revient à dire que les coefficients $b_j$, $T_0$ et $\omega_p$ sont donnés. Le choix de cette fonction de transfert dépend comme on l'a dit de l'application considérée.

La fonction de transfert de la structure théorique représentée par les blocs fonctionnels sur la figure 3a, est conforme à la relation (2).

Dans cette équation, $H_j(s)$ est la fonction de transfert, en tension, du bloc j choisi parmi l'un des blocs $C_1$ à $C_6$ du circuit de la figure 3a par exemple, cette fonction de transfert étant considérée entre la sortie reliée à l'entrée du bloc suivant et l'entrée de ce bloc, c'est-à-dire par exemple pour le bloc $C_2$, entre le noeud 122 et le noeud 121. On écrira ensuite la relation (3).

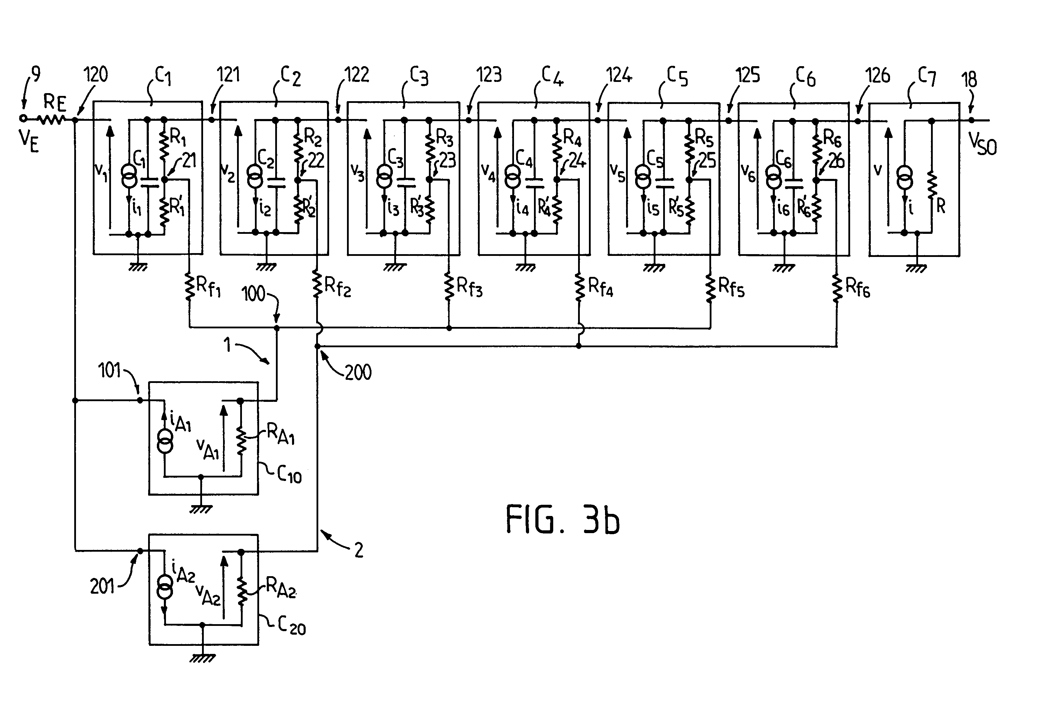

Selon l'invention, pour éviter les inconvénients inhérents au circuit connu de la demande de brevet citée c'est-à-dire le fonctionnement basse-fréquence dû aux amplificateurs opérationnels et la dispersion des valeurs des résistances résultant en un circuit difficilement intégrable, on a choisi d'implémenter le circuit fonctionnel représenté sur la figure 3a, par un circuit dont le schéma équivalent est représenté sur la figure 3b.

Sur la figure 3b, les blocs $C_j$ sont les blocs équivalents aux blocs-filtres $C_j$ de la structure de filtre de la figure 3a. L'entrée $v_j$ des blocs $C_j$ se fait sur une impédance élevée. La sortie est une source de courant $i_j$ commandée en tension avec, en parallèle, un condensateur $c_j$, et un pont de résistances formé de deux résistances en série $R_j$, $R'_j$ respectivement.

Sur la figure 3b, l'entrée du premier bloc $C_1$ se fait au noeud 120, et la sortie au noeud 121. Les blocs $C_j$ sont couplés en série comme décrit précédemment en référence avec la figure 3a.

Dans la pratique l'impédance d'entrée d'un bloc $C_j$ se trouve être en parallèle sur l'impédance de sortie du bloc $C_{j-1}$ précédent.

Par le pont des résistances $R_j$, $R'_j$ formant avec la capacité $c_j$ un filtre R-C associé à chaque source de courant $i_j$, on prélève une fraction de la tension de sortie de chaque bloc $C_j$ pour l'appliquer sur l'une des deux chaînes de réactions multiples 1 ou 2 comme déjà décrit en référence avec la figure 3a. Ce moyen évite de devoir utiliser des résistances de valeurs trop fortes ou de valeurs trop dispersées pour être intégrées. Il en résulte un avantage technologique pour le concepteur de circuits intégrés.

Les chaînes 1 et 2 de réactions multiples comprennent d'abord, entre le point commun des ponts de résistances $R_j$, $R'_j$ et le noeud 100 pour la chaîne 1, et 200 pour la chaîne 2, des résistances respectivement $R_{fj}$ couplées aux blocs filtres $C_j$.

Ainsi, comme montré sur la figure 3b, les résistances $R_{f1}$, $R_{f3}$, $R_{f5}$ sont connectées au point milieu des ponts de résistances, respectivement 21, 23, 25 des blocsfiltres $C_j$ d'ordre impair, alors que les résistances $R_{f2}$, $R_{f4}$, $R_{f6}$ sont connectées au point milieu des ponts de résistances, respectivement 22, 24, 26 des blocs filtres $C_j$ d'ordre pair.

Les résistances $R_{fj}$ d'ordre impair, c'est-à-dire $R_{f1}$, $R_{f2}$, $R_{f5}$, en référence avec la figure 3b, sont en outre connectées par leur seconde extrémité au noeud 100 pour la chaîne 1. D'autre part, les résistances $R_{fj}$ d'ordre pair, c'est-à-dire les résistances $R_{f2}$, $R_{f4}$, $R_{f6}$ en référence avec la figure 3b, sont en outre connectées par leur seconde extrémité au noeud 200 pour la chaîne 2.

Les chaînes de réactions multiples comprennent en outre, entre le noeud 100 commun aux résistances respectives $R_{f1}$ de rang impair et le noeud 101 pour la chaîne 1, et d'autre part entre le noeud 200 commun aux résistances $R_{fj}$ de rang pair et le noeud 201 pour la chaîne 2, des blocs respectivement $C_{10}$ et $C_{20}$. Le bloc $C_{10}$ disposé entre le noeud 100 et le noeud 101 de la chaîne 1, comprend une source de courant $i_{A1}$ et une résistance $R_{A1}$ aux bornes de laquelle on trouve la tension $V_{A1}$. Le bloc $C_{20}$ disposé entre le noeud 200 et le noeud 201 de la chaîne 2 comprend la source de courant $i_{A2}$ et une résistance $R_{A2}$ aux bornes de laquelle on trouve la tension $V_{A2}$.

Les blocs $C_{10}$ et $C_{20}$ des chaînes 1 et 2 sont donc des sources de courant commandées en tension de sens opposé pour obtenir respectivement un gain positif dans la chaîne 1 et négatif dans la chaîne 2. Les sorties des blocs 10 et 20, respectivement au noeud 101, et 201 pour les chaînes 1 et 2 en référence avec la figure 3b, sont couplées au noeud 120 d'entrée du premier bloc-filtre $C_1$ de la chaîne directe.

Le signal d'entrée $V_E$ à filtrer, est introduit au noeud 9, et se propage vers le noeud 120 d'entrée de la structure de filtre à travers une résistance $R_E$.

Tel que représenté sur la figure 3b, le circuit comporte en outre, en cascade avec le dernier bloc filtre de la chaîne, un bloc tampon $C_7$ qui est également une source de courant i commandée en tension. Cette source de courant est en parallèle avec une résistance de charge $R_L$. Le signal de sortie $V_{SO}$ est disponible en sortie du bloc-tampon $C_7$ au noeud 18.

En reprenant les calculs précédents et en les appliquant maintenant à un circuit tel que celui de la figure 3b, il vient les relations (4) et (5)

où $g_{mj}$ est définie par $i_j = g_{mj} \times V_j$

et où $R_{Tj}$ est un paramètre intermédiaire du calcul.

Le calcul se poursuit par les relations (6), (7), (8),

où $R''_j$ est un paramètre intermédiaire du calcul.

L'équation (4) n'est pas rigoureusement exacte, mais légèrement approximative. L'approximation consiste à considérer les tension $V_{A1}$ et $V_{A2}$ comme faibles. En pratique ces conditions sont très bien vérifiées car on utilise des valeurs de résistances $R_{A1}$ et $R_{A2}$ faibles. On choisit en effet les valeurs de $R_{A1}$ et $R_{A2}$ faibles pour que ces résistances shuntent bien les capacités grilles-sources des transistors qui seront inclus dans les blocs A, et $A_2$ des chaînes de contre-réaction, ce qui évite que les caractéristiques des montages pratiques ne soient dégradées par rapport aux caractéristiques prévues.

La mise en équation du circuit représenté sur la figure 3b conduit aux relations (9), (10) et (11).

Dans ces équations on a supposé à titre purement exemplatif, comme il a été dit, que n est pair, et on a noté p par la relation (12).

Comme on l'a vu, n pourrait tout aussi bien être impair. On suppose cependant que n est pair dans toute la suite de l'exposé.

D'autre part, $\beta_j$ est défini comme étant le rapport entre la tension au point de sortie d'un bloc $C_j$ qui est relié à $R_{fj}$, et la tension au point de sortie du bloc $C_j$ qui est relié à l'entrée du bloc (j+1). Par exemple entre la tension au noeud 23 du bloc $C_3$ de la figure 3b, et la tension au noeud 123. On considère que j = 3 pour le bloc $C_3$.

En utilisant la même approximation que pour l'équation (4), on obtient la relation (13).

Après avoir choisi arbitrairement, dans une gamme adéquate dépendant de l'application envisagée pour le circuit, les fonctions de transfert $H_j(s)$ que l'on veut utiliser, c'est-à-dire les valeurs de leurs paramètres $G_j$ et $\omega_j$, on réalise l'identification entre les relations (1) et (2) pour exprimer $\alpha$ et les $F_{\ell k}$ en fonction de $T_0$, des $b_i$ et des $G_k$ et $\omega_j$. Cette identification permet de choisir ces $\alpha$ et $F_{\ell k}$ pour que le circuit de la figure 3b possède la fonction de transfert T(s) souhaitée.

Nous détaillerons ici cette identification, à titre d'exemple pour l'homme du métier, dans le cas particulier où les $\omega_j$ sont toutes identiques. On va noter $\lambda$ le rapport entre leur valeur commune et $\omega_p$. Il s'ensuit la relation (14) vérifiée quel que soit j, où :

$\lambda$ est un paramètre que l'on peut choisir librement en fonction de l'application envisagée.

L'identification entre (1) et (2) conduit aux relations (15) et (16).

La relation (16) permet de calculer $\alpha$ et donc l'un des paramètres $g_m$ et $R_L$, en choisissant l'autre arbitrairement en fonction de l'application envisagée.

La relation (15) permet de calculer les $F_{\ell k}$ par récurrence, puisque de cette relation (15) on déduit la relation (17), et on déduit également la relation (18), vraie quel que soit k tel que k > 1.

Une fois que les $F_{\ell k}$ sont connus, on peut en déduire les $R_{fk}$. En effet, de la relation (10), on peut déduire la relation (19).

De même, de la relation (11), il vient la relation (20). Les valeurs de $R_j$, $G_{mA1}$, $G_{mA2}$, $R_{A1}$, $R_{A2}$, sont choisies arbitrairement dans une gamme adéquate.

On choisit également l'un des deux paramètres $g_{mj}$ ou $R_{Tj}$ arbitrairement. La relation (5) permet alors de déterminer l'autre, suivant la valeur de $G_j$ choisie au départ.

A ce stade $R_{Tj}$ est donc connu et $\omega_j$ a été choisi, donc la relation (6) permet de connaître $C_j$. Une possibilité équivalente consiste à choisir $C_j$, à en déduire $R_{Tj}$ par la relation (6) puis $G_{mj}$ par la relation (5).

A partir de $R_{Tj}$, on déduit ensuite $R_j$ et $R''_j$ par les relations (7) et (8). Puis de $R''_j$, on déduit $R'_j$ par la relation (8).

On a ainsi explicité comment l'homme du métier peut calculer les valeurs de tous les éléments en fonction de quelques paramètres et de quelques valeurs d'éléments choisies arbitrairement au départ.

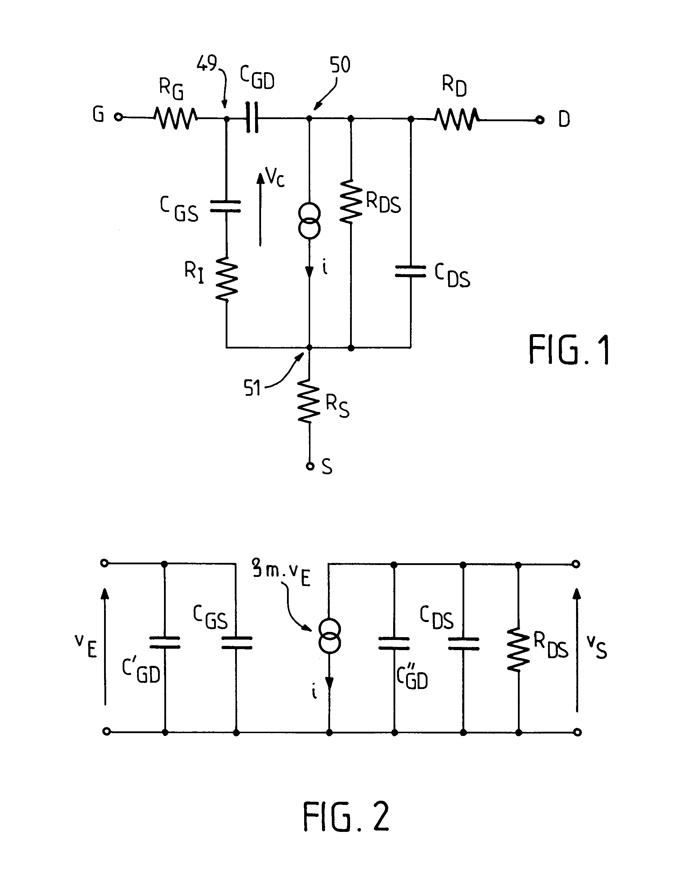

L'étape suivante consiste à implémenter le montage théorique représenté sur la figure 3b. A cet effet on considère le schéma équivalent à un transistor à effet de champ qui est représenté sur la figure 1.

6

Ainsi, tel que représenté sur la figure 1, un transistor à effet de champ $T_i$ est modélisé par quatre sections de branches en parallèle comprenant :
- une première branche comportant la capacité $C_{GS}$ qui existe entre la grille G et la source S du transistor, en série avec la résistance intrinsèque $R_I$ ;
- une seconde branche comportant une source de courant i ;
- une troisième branche comportant la résistance $R_{DS}$ qui existe entre le drain D et la source S du transistor ;
- une quatrième branche comportant la capacité $C_{DS}$ qui existe entre le drain D et la source S du transistor.

Un des points de couplage 51 de ces quatre branches est relié à la source S à travers la résistance de source $R_S$. L'autre point de couplage 50 des seconde, troisième et quatrième branches est relié au drain D à travers la résistance de drain $R_D$. L'autre point de couplage 49 de la première branche est relié d'une part au point de couplage 50 des trois autres branches à travers la capacité grille-drain $C_{GD}$ et d'autre part à la grille G à travers la résistance de grille $R_G$.

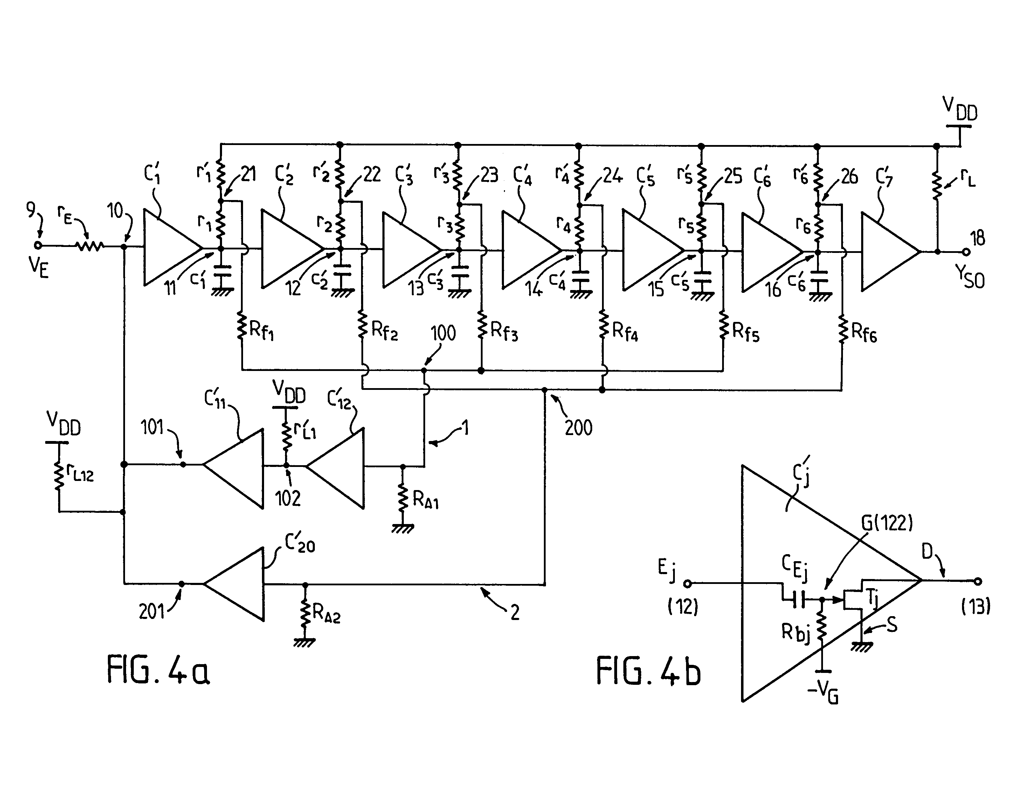

Tel que représenté sur la figure 4b, on peut, à l'aide de ce transistor à effet de champ, réaliser un étage amplificateur élémentaire à gain négatif.

Cet étage amplificateur élémentaire, noté $C'_j$ comporte, selon l'invention, un transistor à effet de champ $T_j$ dont le drain D constitue la sortie. L'entrée $E_j$ de cet étage amplificateur élémentaire est reliée à la grille G du transistor à effet de champ par le moyen d'une capacité $c_{Ej}$, cette grille G étant par ailleurs reliée à une tension de polarisation à travers une résistance $R_{bj}$.

Si l'on tient compte à la fois des éléments intrinsèques au transistor à effet de champ $T_j$, et des éléments réels de l'étage amplificateur élémentaire $C'_j$, alors le circuit représenté sur la figure 4a, utilisant de tels étages amplificateurs élémentaires admet pour schéma équivalent la structure déjà décrite en référence avec la figure 3b et recherchée pour résoudre le problème technique posé.

Ainsi, la modélisation du transistor à effet de champ $T_j$ selon le schéma de la figure 1, conduit à réaliser l'implémentation du circuit théorique de la figure 3b par le circuit de la figure 4a en coopération avec le circuit de la figure 4b où j représente l'ordre des blocs-filtres.

Du fait que l'on tient compte des éléments intrinsèques du transistor à effet de champ $T_j$, dans le circuit implémenté de la figure 4a, les résistances du pont diviseur prennent des valeurs spécifiques $r_j$, $r'_j$ et les résistances $R_E$, $R_L$ de la chaîne directe prennent des valeurs $r_E$ et $r_L$ définies par des relations données plus loin. Les résistances $r'_j$ des ponts diviseurs et la résistances $r_L$ sont reliées à l'alimentation continue positive $V_{DD}$.

Dans les chaînes de réaction les résistances $R_{A1}$, $R_{A2}$ et $R_{fj}$ sont inchangées par rapport au circuit théorique de la figure 3b. Les valeurs de $R_{A1}$ et $R_{A2}$ sont données plus loin. Dans la première chaîne, le bloc $C_{10}$ disposé entre les noeuds 100 et 101, comprend deux étages amplificateurs élémentaires à gain négatif $C'_{12}$, $C'_{11}$ en cascade, dont le point de couplage 102 est relié à l'alimentation continue positive $V_{DD}$ à travers une résistance $r'_{L1}$. Par ailleurs, la sortie 101 du second étage amplificateur élémentaire est polarisée par rapport à l'alimentation continue positive $V_{DD}$ à travers une résistance $r_{L12}$. Dans la seconde chaîne de réaction, le bloc $C_{20}$ disposé entre les noeuds 200 et 201 comprend un étage amplificateur à gain négatif $C'_{20}$. La sortie 201 de cet étage est polarisée également par rapport à l'alimentation continue $V_{DD}$ à travers la résistance $r_{L12}$. Les noeuds 101 et 201 sont reliés directement au noeud 10 de la chaîne directe.

L'étage tampon $C'_7$ correspondant au bloc tampon $C_7$ de la figure 3b, est simplement formé d'un étage amplificateur élémentaire dont la sortie est polarisée par rapport à l'alimentation continue positive $V_{DD}$ à travers la résistance $r_L$. La sortie $V_{SO}$ du circuit complet est disponible au noeud de sortie 18 de cet étage tampon $C'_7$.

En considérant comparativement le circuit théorique de la figure 3b et le circuit réel des figures 4a et 4b, on constate que les noeuds 121 à 126 en référence avec la figure 3b se trouvent coïncider avec la grille G des transistors à effet de champ $T_j$ du circuit en référence avec les figures 4a, 4b, du fait des valeurs élevées choisies pour $c_{Ej}$ et $R_{bj}$.

L'utilisation de l'étage tampon $C'_7$ est importante. En effet s'il se trouvait après le dernier bloc filtre $C_j$ du circuit, un autre circuit dont l'impédance d'entrée pourrait contenir une capacité, il s'introduirait alors un pôle supplémentaire dans la fonction de transfert de la structure de filtre. Grâce au bloc tampon $C'_7$, la résistance et la capacité du dernier bloc-filtre ne sont pas modifiées. Donc les réactions qui se produisent dans la fonction de transfert ne le sont pas non plus. Si au contraire le bloc tampon n'existait pas, il faudrait prendre en compte, dans le calcul de la structure filtrante, l'impédance d'entrée du circuit ultérieur qui charge cette structure.

Comme on l'a dit, le fonctionnement de la structure de filtre de la figure 4a associée à la figure 4b, s'explique par le modèle du transistor à effet de champ de la figure 1. Cependant certains éléments ont une influence négligeable, tels que les résistances de grille $R_G$, de source $R_S$, de drain $R_D$ et la résistance intrinsèque grille-source $R_I$. En outre, la capacité $C_{GD}$ peut être remplacée en première approximation par deux capacités $C'_{GD} = (1+G)C_{GD}$ et $C''_{GD} = (1 + 1/G)C_{GD}$, où $G = g_m.R_{DS}$ est le gain basse-fréquence de l'étage. Si bien qu'en première approximation, le modèle du transistor de la figure 1, devient le modèle de transistor représenté sur la figure 2.

Ainsi, la modélisation du circuit de la figure 4a est bien le circuit de la figure 3b. On retrouve une cascade de résistance et capacité en parallèle avec des sources de courant. En effet, tous les éléments intrinsèques des transistors à effet de champ viennent se mettre en parallèle avec les autres éléments du montage.

Dans le montage représenté sur la figure 3b, tous les éléments parasites essentiels du circuit de figure 4a sont pris en compte.

Dans la représentation théorique de la figure 3b, on a supposé que l'impédance d'entrée de chaque cellule $C_1$ à $C_6$ était infinie.

On pourrait aussi considérer comme possible le fait d'avoir une capacité et une résistance en parallèle à l'entrée de chaque cellule, qui s'ajouteraient à la résistance et la capacité de sortie de la cellule précédente.

Grâce à l'utilisation de deux cellules dans une des chaînes de retour (chaîne 1) et d'une seule cellule dans l'autre chaîne (chaîne 2), les deux chaînes de retour ont des gains de signe opposé, qui peuvent être de valeur différente.

Dans l'implémentation des chaînes de retour selon le circuit représenté sur la figure 4a, il s'introduit quelques capacités qui ne sont pas voulues a priori, mais qui ne sont pas gênantes pour atteindre aux buts de l'invention. Ce qui est par contre particulièrement avantageux est que les deux chaînes de retour 1 et 2, à gain négatif et positif, sont implémentées avec un nombre d'éléments particulièrement faible, que le circuit est ainsi facilement intégrable, et que le fonctionnement dans le domaine des hyperfréquences est atteint. Donc les avantages sont grands devant les inconvénients. Ces capacités parasites ne peuvent en fait dégrader de façon notable les performances de l'ensemble du circuit car elles sont négligeables. En effet, dans le montage pratique, on est amené à utiliser pour les résistances $R_{A1}$ et $R_{A2}$ des valeurs assez faibles. De ce fait, ces résistances shuntent la capacité grille-source $G_{CS}$ du transistor utilisé pour réaliser la source de courant des blocs $C_{10}$ et $C_{20}$ des chaînes de retour. Donc $C_{GS}$ ne sera pas visible dans les cellules des chaînes de retour et $C_{DS}$ (capacité drainsource) en sortie desdits blocs a une valeur assez faible. Ce qui amène à utiliser pour charger les étages $C'_{11}$, $C'_{12}$, $C'_{20}$, des résistances $r'_{L1}$, $r_{L12}$, de valeurs assez faibles. Il en résulte que la fréquence de coupure en sortie de ces étages, qui est définie par $r_L$ et $C_{DS}$ sera rejetée assez haut, et que les capacités parasites auront donc une très faible influence.

La dernière étape de l'implémentation consiste, au moyen des calculs relatifs au montage théorique, à calculer les valeurs des éléments du montage réel de la figure 4 (4a et 4b). Ce qui se fait à l'aide des équations (21), (22), (23), (24).

Ces relations permettent de calculer les valeurs des éléments effectivement insérés dans le circuit réel de la figure 4, c'est-à-dire $r_j$, $r'_j$ et $c'_j$, quand on connaît les valeurs des paramètres intrinsèques des transistors à effet de champ utilisés pour réaliser les cellules montrées sur la figure 4b, c'est-à-dire :

$C_{GSj}$ capacité grille-source d'un transistor j

$C_{DSj}$ capacité drain-source d'un transistor j

$C_{GDj}$ capacité grille-drain d'un transistor j

$R_{DSj}$ résistance drain-source d'un transistor j

Dans l'équation (21), le gain $G'_j = G_j$ (utilisé dans l'étude théorique), si j > 1 et si la relation (24bis) est vérifiée, relation (24bis) dans laquelle $R_0$ est défini plus loin par la relation (28).

Les dernières relations montrent que les éléments intrinsèques des transistors $T_j$ sont pris en compte dans la conception du circuit réel. Cela permet à la structure de filtre de fonctionner en hyperfréquences, alors que les circuits connus de l'état de la technique considèrent les éléments intrinsèques commme des éléments parasites. En effet, il n'était pas possible dans les circuits connus de prendre en compte ces éléments parasites.

Si les éléments intrinsèques ne sont pas pris en compte, ils vont dégrader les performances prévues, de manière innacceptable en hyperfréquences.

Dans chaque étage amplificateur élémentaire du type de celui de la figure 4b, les $C_{Ej}$ et $R_{bj}$ sont choisies suffisamment grandes pour que leur effet soit négligeable. Leurs valeurs pourront donc être choisies arbitrairement.

Les largeurs de grille des transistors $T_j$ des étages amplificateurs $C'_j$ de la chaîne directe, y compris l'étage tampon, seront choisies de manière à ce que leurs transconductances $g_{mj}$ soient égales aux valeurs

EP 0 475 532 A1

utilisées dans les étapes relatives à l'étude de la structure théorique, à l'exception du bloc 1.

Lorsque les largeurs de grille des transistors sont connues, les valeurs de leurs éléments intrinsèques sont entièrement définies (pour un type de transistor donné), donc ces valeurs sont effectivement utilisables dans le relations (21) à (24).

En outre la valeur de la résistance $r_L$ est définie par la relation (25) où $R_{DS}$ est connue. En effet, on choisit la largeur de grille du transistor de l'étage tampon de façon à ce que sa transconductance soit égale à la transconductance $g_m$ utilisée dans l'étude de la structure théorique. La largeur de grille du transistor étant connue, sa résistance drain-source $R_{DS}$ est définie.

Il est encore possible de choisir un transistor ayant une transconductance $g'_m$ différente de $g_m$ de l'étude théorique. Il faudrait alors choisir $r_L$ de façon à ce que la relation (25bis) soit vérifiée.

D'autre part, la largeur de grille du transistor de l'étage de retour $C'_{20}$ sera choisie de manière à ce que sa transconductance soit égale à $g_{m2O}$ de l'étude théorique. (On notera $R_{DS2O}$ sa résistance drain-source).

En outre, les largeurs de grille des deux transistors des étages $C'_{11}$ et $C'_{12}$ (ces 2 transistors ayant respectivement pour résistances drain-source $R_{DS11}$ et $R_{DS12}$ et pour transconductances $g_{m11}$ et $g_{m12}$) et la résistance $r'_{L1}$ sera choisie de manière à ce que la relation (26) soit vérifiée, relation (26) dans laquelle $g_{mA}$ est la valeur utilisée dans l'étude théorique précédente. Cette condition (26) laisse certains degrés de liberté.

Par ailleurs, la largeur du transistor de l'étage 1 sera choisie de façon à ce que sa transconductance $g'_{m1}$ ait la valeur donnée par la relation (27), dans laquelle $g_{m1}$ est la transconductance du premier étage utilisée dans l'étude théorique, $R_0$ étant définie par la relation (28), et $r_E$ étant définie par la relation (29).

Le choix de la largeur du transistor du premier étage est donc choisi conjointement à celui de $r_{L12}$ et $r_E$, ce qui donne lieu à des degrés de liberté.

On notera encore que sur la figure 3a, on n'a pas représenté le bloc tampon qui existe sur les figures 3b et 4a.

Le tableau 2 donne la valeur des éléments en référence avec les figures 4a et 4b pour réaliser un exemple de structure filtrante passe-bas, selon l'invention.

9

**TABLEAU 1**

$$T(s) = \frac{T_0 b_0}{(s/w_p)^n + b_{n-1}\,(s/w_p)^{n-1} + \ldots + b_0} \qquad (1)$$

$$F(s) = \frac{\alpha \cdot \displaystyle\prod_{j=1}^{n} H_j(s)}{1 + \displaystyle\sum_{k=1}^{n} F_{\ell k} \cdot \prod_{j=1}^{k} H_j(s)} \qquad (2)$$

$$H_j(s) = \frac{v_{j+1}}{v_j} \qquad (3)$$

$$H_j(s) \simeq \frac{-G_j}{(s/w_j)+1} \qquad (4)$$

$$\text{avec } G_j = g_{mj} \cdot R_{Tj} \qquad (5)$$

$$w_j = \frac{1}{R_{Tj} \cdot c_j} \qquad (6)$$

$$R_{Tj} = R_j + R''_j \qquad (7)$$

$$\frac{1}{R''_j} = \frac{1}{R'_j} + \frac{1}{R_{fj}} \qquad (8)$$

$$\alpha = -g_m \cdot R_L \qquad (9)$$

**TABLEAU 1 (suite)**

$$F_{\ell(2k-1)} = \frac{R_j \cdot g_{mA1} \times \dfrac{R_{A1}}{R_{f(2k-1)}}}{1 + R_{A1} \displaystyle\sum_{j=1}^{p} \dfrac{1}{R_{f(2j-1)}}} \times \beta_{(2k-1)} \quad (10)$$

$$F_{\ell(2k)} = \frac{R_j \cdot g_{mA2} \times \dfrac{R_{A2}}{R_{f(2k)}}}{1 + R_{A2} \displaystyle\sum_{j=1}^{p} \dfrac{1}{R_{f(2j)}}} \times \beta_{(2k)} \quad (11)$$

$$p = \frac{n}{2} \quad (12)$$

$$\beta_j = \frac{R''_j}{R_j + R''_j} \quad (13)$$

$$\omega_j = \lambda \, \omega_p \quad (14)$$

$$b_{n-k} = \lambda^k \left[ C_k^n + \sum_{j=1}^{k} F_{\ell j} \, C_{n-k}^{n-j} \cdot \prod_{i=1}^{j} G_i \right] \quad (15$$

$$T_0 \, b_0 = -\alpha \left( \prod_{j=1}^{2p} G_j \right) \lambda^{2p} \quad (16)$$

## TABLEAU 1 (suite)

$$F_{\ell 1} = \frac{1}{G_1} \left[ \frac{b_{n-1}}{\lambda} - n \right] \qquad (17)$$

$$F_{\ell k} = \frac{1}{\prod\limits_{j=1}^{k} G_j} \left[ \frac{b_{n-k}}{\lambda} - C_k^n \right] - \sum\limits_{j=1}^{k-1} F_{\ell j} \, C_{n-k}^{n-j} \, \frac{1}{\prod\limits_{i=j+1}^{k} G_i} \qquad (18)$$

$$R_{f(2k-1)} = R_{A1} \, \frac{\beta_{2k-1}}{F_{\ell(2k-1)}} \left[ R_j \cdot g_{mA1} - \sum\limits_{j=1}^{p} \frac{F_{\ell(2j-1)}}{\beta_{(2j-1)}} \right] \qquad (19)$$

$$R_{f(2k)} = R_{A2} \, \frac{\beta_{2k}}{F_{\ell(2k)}} \left[ R_j \cdot g_{mA2} - \sum\limits_{j=1}^{p} \frac{F_{\ell(2j)}}{\beta_{(2j)}} \right] \qquad (20)$$

$$C_i = (1 + \frac{1}{G'_i}) \, C_{GDi} + C_{DSi} + C'_i + (1+G'_{(i+1)}) C_{GD(i+1)} + C_{GS(i+1)} \quad (21)$$

$$\frac{1}{R_{Ti}} = \frac{1}{R_{DSi}} + \frac{1}{r_i + r''_i} \qquad (22)$$

$$\beta_i = \frac{r''_i}{r_i + r''_i} \qquad (23)$$

$$\frac{1}{r''_i} = \frac{1}{r'_i} + \frac{1}{R_{fi}} \qquad (24)$$

$$G'_1 = \frac{1}{1 - \dfrac{r_E}{R_0}} \times G_1 \qquad (24bis)$$

**TABLEAU 1 (suite)**

$$\frac{1}{R_L} = \frac{1}{r_L} + \frac{1}{R_{DS}} \qquad\qquad (25)$$

$$g_m \cdot R_L = g'_m \; \frac{1}{\dfrac{1}{r_L} + \dfrac{1}{R_{DS}}} \qquad\qquad (25bis)$$

$$g_{m12} \; x \; \frac{1}{\dfrac{1}{r'_{L1}} + \dfrac{1}{R_{DS12}}} \; x \; g_{m11} = g_{mA1} \qquad\qquad (26)$$

$$g'_{m1} = \frac{1}{1 - \dfrac{R_E}{R_0}} \cdot g_{m1} \qquad\qquad (27)$$

$$\frac{1}{R_0} = \frac{1}{r_{L12}} + \frac{1}{R'_{DS11}} + \frac{1}{R_{DS20}} \qquad\qquad (28)$$

$$R_E = + \frac{r_E}{1 - \dfrac{r_E}{R_0}} \qquad\qquad (29)$$

**TABLEAU 2**

| $W_{T1}$ = 10 µm | $r_1$ = 0 | $r'_1$ = 1141 Ω | $C'_1$ = 0,93pF | $Rf_1$ = ∞ |
|---|---|---|---|---|
| $W_{T2}$ = 71,5 µm | $r_2$ = 0 | $r'_2$ = 5755 Ω | $C'_2$ = 0,92pF | $Rf_2$ = 3262 Ω |
| $W_{T3}$ = 71,5 µm | $r_3$ = 6025 Ω | $r'_3$ = 1767 Ω | $C'_3$ = 0,92pF | $Rf_3$ = 10218 Ω |
| $W_{T4}$ = 71,5 µm | $r_4$ = 3765 Ω | $r'_4$ = 6157 Ω | $C'_4$ = 1 pF | $Rf_4$ = 9695 Ω |
| $W_{T5}$ = 10 µm | $r_5$ = 856 Ω | $r'_5$ = 295 Ω | $C'_5$ = 1,01pF | $Rf_5$ = 8892 Ω |
| $W_{T6}$ = 10 µm | $r_6$ = 571 Ω | $r'_6$ = 618 Ω | $C'_6$ = 0,93pF | $Rf_6$ = 7405 Ω |
| $W_{T7}$ = 70 µm | $r_L$ = 50 Ω | | | |

$W_{T11}$ = 200 µm

| $R_{A1}$ = 50 Ω | $R_{A2}$ = 50 Ω | $W_{T20}$ = 220 µm |
|---|---|---|
| $W_{T12}$ = 10 µm | $r_E$ = 100 Ω | |
| $r_{L12}$ = 100 Ω | $r'_{L1}$ = 100 Ω | |

## Revendications

1. Dispositif semiconducteur intégré incluant une structure de filtre passe-bas à réactions multiples, cette structure comprenant une chaîne directe formée d'au moins deux blocs-filtres à gain négatif montés en série, et deux chaînes de réactions multiples, la première à gain négatif, la seconde à gain positif ramenant les signaux de sortie des blocs-filtres sur l'entrée de la structure de filtre à travers un sommateur, caractérisé en ce que :

- chaque bloc-filtre de la chaîne directe est un passe-bas d'ordre 1 comprenant un circuit R-C et un étage amplificateur à gain négatif formant une source de courant commandée en tension dont les éléments réels et intrinsèques sont pris en compte dans la structure du circuit R-C pour le calcul de la fonction de transfert,

- la première chaîne de réactions multiples renvoie sur l'entrée de la structure de filtre une première somme de fractions de toutes les tensions de sortie des blocs-filtres de position paire de la chaîne directe pondérées par des coefficients d'amplification négatifs,
- la seconde chaîne de réactions multiples renvoie sur l'entrée de la structure de filtre une seconde somme de fractions de toutes les tensions de sortie des blocs-filtres de position impaire de la chaîne directe pondérées par des coefficients d'amplification positifs.

2. Dispositif selon la revendication 1, caractérisé en ce que la structure des chaînes de réactions multiples comporte une liaison des sorties de chaque bloc-filtre de la chaîne directe, à travers des résistances respectives à l'entrée d'un étage amplificateur à gain négatif chargé pour la première chaîne, et à l'entrée d'un étage amplificateur à gain positif chargé pour la seconde chaîne, les étages amplificateurs formant chacun une source de courant commandée en tension dont les éléments réels et intrinsèques sont pris en compte dans les structures produisant les coefficients d'amplification pour le calcul de la fonction de transfert.

3. Dispositif selon la revendication 2, caractérisé en ce que la sortie du dernier bloc-filtre est appliquée sur l'entrée d'un bloc-tampon formé d'un étage amplificateur à gain négatif chargé, formant une source de courant commandée en tension, dont les éléments réels et intrinsèques sont pris en compte dans la fonction de transfert de la structure de filtre.

4. Dispositif selon l'une des revendications 2 ou 3, caractérisé en ce que les structures pour prélever une fraction des sorties des blocs-filtres de la chaîne directe sont des ponts diviseurs à résistances constituant respectivement les charges des étages amplificateurs de la chaîne directe.

5. Dispositif selon l'une des revendications précédentes, caractérisé en ce que les étages amplificateurs à gain négatif sont formés d'un nombre impair d'étages amplificateurs élémentaires à gain négatif, et les étages amplificateurs à gain positif d'un nombre pair de tels étages amplificateurs élémentaires.

6. Dispositif selon la revendication 5, caractérisé en ce que chaque étage amplificateur élémentaire à gain négatif est formé d'un transistor à effet de champ, d'une capacité reliant l'entrée de l'étage élémentaire à la grille du transistor à effet de champ, d'une résistance reliant la grille du transistor à une alimentation continue négative, d'une liaison de la source du transistor à la masse, la sortie de l'étage élémentaire s'effectuant sur le drain du transistor.

7. Dispositif selon la revendication 6, caractérisé en ce que le signal d'entrée de la structure de filtre est appliqué à l'entrée du premier étage amplificateur par l'intermédiaire d'une résistance.

8. Dispositif selon la revendication 7, caractérisé en ce que dans les chaînes de réactions les étages amplificateurs élémentaires à gain négatif sont couplés d'une part à la masse et d'autre part à la tension continue positive par des résistances de charge, et en ce que les sorties des étages amplificateurs ainsi formés sont ramenées sur l'entrée du premier étage amplificateur de la chaîne directe par des résistances respectives.

9. Dispositif selon l'une des revendications précédentes, caractérisé en ce que le nombre de blocs-filtres de la chaîne directe est 6.

10. Dispositif selon l'une des revendications 5 à 9, caractérisé en ce que le nombre des étages amplificateurs élémentaires à gain négatif est 1 pour constituer un étage amplificateur à gain négatif et est 2 pour constituer un étage amplificateur à gain positif.

FIG.1

FIG. 2

FIG. 3a

FIG. 3b

FIG. 4a

FIG. 4b

Office européen
des brevets

**RAPPORT DE RECHERCHE
EUROPEENNE**

Numéro de la demande

**EP 91 20 2312**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,Y | US-A-3 720 881 (HURTIG)(13-03-1973) <br> * Colonne 3, ligne 20 - colonne 4, ligne 62; colonne 5, lignes 10-53; colonne 7, lignes 26-65; figures 1-4 * <br> – – – | 1,5,9,10 | H 03 H 11/12 |
| Y | IEEE TRANSACTIONS ON MICROWAVE THEORY AND TECHNIQUES, vol. 37, no. 9, septembre 1989, pages 1418-1424; S.E. SUSSMAN-FORT: "Design concepts for microwave GaAs FET active filters" <br> * Page 1418, colonne de gauche, lignes 11-20; page 1418, colonne de droite, lignes 23-26; page 1420, colonne de gauche, ligne 37 - colonne de droite, ligne 36; page 1421, colonne de droite, lignes 1-49; figures 1,2a * <br> – – – | 1,5,9,10 | |
| A | P. HOROWITZ et al.: "The Art of Electronics", 1980, page 232, Cambridge University Press, Cambridge, GB <br> * Page 232, colonne de droite, lignes 8-20; figure 6.15 * <br> – – – – – | 6 | |

**DOMAINES TECHNIQUES
RECHERCHES (Int. Cl.5)**

H 03 H

Le présent rapport de recherche a été établi pour toutes les revendications

| Lieu de la recherche | Date d'achèvement de la recherche | Examinateur |
|---|---|---|
| La Haye | 17 décembre 91 | WRIGHT J.P. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire
T : théorie ou principe à la base de l'invention

E : document de brevet antérieur, mais publié à la date de dépôt ou après cette date
D : cité dans la demande
L : cité pour d'autres raisons
-------------------------------------------------------------------------
& : membre de la même famille, document correspondant